# EUROPEAN PATENT APPLICATION

(11) **EP 4 141 222 A1**
(43) Date of publication of application: **01.03.2023**
(21) Application number: 21193087.0
(22) Date of filing: 25.08.2021
(51) Int. Cl.: F01K 17/04, B01D 1/28

(54) **AN ENERGY SYSTEM COMPRISING A MECHANICAL VAPOR COMPRESSION (MVC/MVR) SUBSYSTEM AND A METHOD FOR CONVERTING OF ENERGY**

(71) Applicant: Aquafair AB, 702 18 Örebro (SE)
(72) Inventor: ÅHRSTRÖM, Bert-Olof, Örnsköldsvik (SE); CARLMAN, Fredrik, Örebro (SE)
(74) Representative: Bjerkén Hynell KB

(57) **Abstract**

An energy system (1, 1', 1") comprising a mechanical vapor compression (MVC/MVR) subsystem (3) is disclosed. The MVC/MVR-subsystem (3) is arranged to receive a liquid and arranged to produce compressed vapor from said liquid and to heat the liquid being received. The energy system (1, 1', 1") comprises an energy subsystem (5, 5', 5") connected to said MVC/MVR-subsystem (3) and arranged to convert energy in a portion of said compressed vapor and/or in at least a portion of said liquid being heated into another form of energy. A method for converting of energy is also disclosed.

## Description

### Technical field

The present disclosure relates to an energy system comprising a mechanical vapor compression (MVC/MVR) subsystem, in particular it relates to an energy system comprising MVC/MVR liquid purification subsystem. Further, the present disclosure relates to a method for converting of energy using a MVC/MVR-subsystem.

### Background

Mechanical Vapor Compression (MVC) or also called Mechanical Vapor Recompression (MVR) is an evaporation method by which a blower, compressor or jet ejector is used to compress, and as a result of the compression, increase the pressure, density and temperature of the vapor produced.

As a result, the vapor can serve as the heating medium for its "mother" liquid or solution being concentrated. Without the compression, the vapor would be at the same temperature as its "mother" liquid/solution, and no heat transfer could take place.

Below some patent documents within the technical field will be briefly discussed. In the US 10793483 a system is described using a mechanical vapor recompression evaporator (MVR) to receive a liquid fraction from a centrifuge and evaporating the liquid fraction by mechanical vapor recompression to produce ammonia-laden water vapor and a concentrated nutrient slurry. The system comprises a dryer for drying the nutrient slurry to a selected moisture content to be available as an ingredient in compounded fertilizer; and an ammonia stripping tower assembly to receive ammonia-laden water vapor from the MVR and from it to precipitate ammonium sulphate salt and condense water as separate products.

In the EP2716341 a system and a method is described for liquid treatment by mechanical vapor recompression comprising a fixed fluid-tight evaporator housing. The housing comprises an inlet for feeding liquid to be evaporated into the housing and an outlet from the housing for liquid concentrated by evaporation and an outlet from the housing for discharging vapor boiled off from the liquid by evaporation. The housing comprises a plurality of heating elements within the housing mounted on a common horizontal axis, each of said heating elements having an outer surface for contact with said liquid to be evaporated within the housing and having an internal passage for heating medium and an element inlet and an element outlet for the heating medium.

In the EP3689449 a system for energy recycling using mechanical vapor recompression in combined chemical process is described.

Although the known systems work well, there is a need of improvements regarding utilization of energy from a MVC/MVR in an efficient manner.

Thus, the general object of the present disclosure is to achieve an energy system comprising a mechanical vapor recompression (MVC/MVR) subsystem, which energy system has conditions for an improved utilization of energy from the MVC/MVRsubsystem. Further, an object of the present disclosure is to achieve an improved method for converting of energy using a MVC/MVR-subsystem in an efficient manner.

### Summary

The above-mentioned objects are achieved by the present disclosure according to the independent claims.

Preferred embodiments are set forth in the dependent claims.

According to one aspect, the present disclosure relates to an energy system comprising a mechanical vapor compression MVC/MVR subsystem arranged to receive a liquid and arranged to produce compressed vapor from said liquid and to heat the liquid being received. The energy system comprises an energy subsystem connected to the MVC/MVR-subsystem and arranged to convert energy in a portion of said compressed vapor and/or in at least a portion of the liquid being heated into another form of energy. At least a portion of the liquid being heated means that the entire volume of the heated liquid can be used in the energy subsystem or a portion of the heated liquid can be used in the energy subsystem.

Because the energy system comprises the energy subsystem connected to the MVC/MVRsubsystem, a portion of energy produced by the MVC/MVR-subsystem can be used in the energy subsystem to be converted into another form of energy.

Thus, the energy subsystem can utilize a portion of energy produced by the MVC/MVR-subsystem by using the portion of the compressed vapor produced in the MVC/MVR-subsystem and converting the energy in the portion of the compressed vapor into another form of energy that can be useful.

As an alternative, the energy subsystem can utilize a portion of energy produced by the MVC/MVR-subsystem by using at least the portion of the liquid being heated and converting the energy in at least the portion of the liquid being heated into another form of energy that can be useful.

As a further alternative, the energy subsystem can utilize a portion of energy produced by the MVC/MVR-subsystem by using both the portion of the compressed vapor produced in the MVC/MVR-subsystem and at least the portion of the liquid being heated in the MVC/MVR-subsystem and converting the energy in the portion of the compressed vapor and in at least the portion of the liquid being heated into another form of energy that can be useful.

Thus, an energy system is provided, which system has conditions for utilization of a portion of energy produced in the MVC/MVR-subsystem in an efficient manner for converting the energy into another form of energy that can be used.

Consequently, an improved energy system is provided, which energy system has conditions for an improved utilization of energy produced by a MVC/MVR-subsystem.

Therefore, the above mentioned object is achieved.

Optionally, the energy subsystem comprises a cooling apparatus configured to convert heat to cooling. Thus, heat produced by the MVC/MVR-subsystem can be used to produce cooling, such as for example cooling of residences or cooling in industrial processes.

Optionally, the cooling apparatus is an absorption chiller or an adsorption chiller. Thus heat energy produced by the MVC/MVR-subsystem can be converted into cooling in an efficient manner by means of an absorption chiller or an adsorption chiller. Another examples of cooling apparatus are thermodynamic cyclic processes, such as ORC, Stirling cycle, thermo-acoustics, adsorption- or absorption-refrigerators or electro-thermal converters such as Peltier elements.

Optionally, the energy subsystem comprises an electric apparatus configured to use heat to generate electricity. Thus, heat produced by the MVC/MVR-subsystem can be used to produce electricity.

Optionally, the electric apparatus is a thermoelectric generator. Thus, electricity can be produced in an effective manner.

Optionally, the MVC/MVR-subsystem is arranged as a closed loop vapor MVC/MVR-subsystem. Thus, vapor can be used in an efficient manner.

Optionally, the MVC/MVR-subsystem is a MVC/MVR liquid purification subsystem. Thus, an improved energy system is provided having conditions for producing pure liquid by means of the MVC/MVR-subsystem and for producing energy by means of the energy subsystem connected to the MVC/MVR-subsystem.

Optionally, the MVC/MVR liquid purification subsystem is a MVC/MVR water desalination subsystem.

Optionally, the liquid is water and the heated liquid is heated cleaned water. Thus, an yet improved energy system is provided having conditions for producing pure fresh water by means of the MVC/MVR-subsystem and for producing energy by means of the energy subsystem connected to the MVC/MVR-subsystem.

Hot water, being a high-density energy source, can via thermodynamic cyclic processes such as ORC, Stirling cycle, thermo-acoustics, adsorption- and/or absorption refrigeration, electro-thermal converters such as Peltier elements freely become converted into a cold medium such as solid, fluid, gaseous or a combination of them. The cold medium can for example become utilized for purposes of cooling residences or industrial processes, as integral part of district cooling systems (cold water supply), for air conditioning systems or similar.

According to a further aspect the present disclosure relates to a method for converting energy using an energy system comprising a mechanical vapor compression (MVC/MVR) subsystem arranged to receive a liquid and arranged to produce compressed vapor from the liquid and to heat the liquid being received. The method comprises:
- connecting an energy subsystem to the MVC/MVR-subsystem and
- using a portion of the compressed vapor and/or at least a portion of the liquid being heated to convert energy in the portion of the compressed vapor and/or in at least the portion of the liquid being heated into another form of energy by means of the energy subsystem.

Because the energy subsystem is connected to the MVC/MVR-subsystem, a portion of energy produced by the MVC/MVR-subsystem can be used in the energy subsystem.

Thus, the energy subsystem can utilize a portion of energy produced by the MVC/MVR-subsystem by using the portion of the compressed vapor produced in the MVC/MVR-subsystem and converting the energy in the portion of the compressed vapor into another form of energy that can be useful.

As an alternative, the energy subsystem can utilize a portion of energy produced by the MVC/MVR-subsystem by using at least the portion of the liquid being heated and converting the energy in at least the portion of the liquid being heated into another form of energy that can be useful.

As a further alternative, the energy subsystem can utilize a portion of energy produced by the MVC/MVR-subsystem by using both the portion of the compressed vapor produced in the MVC/MVR-subsystem and at least the portion of the liquid being heated in the MVC/MVR-subsystem and converting the energy in the portion of the compressed vapor and in at least the portion of the liquid being heated into another form of energy that can be useful.

Consequently, an improved method for converting of energy is provided. Therefore, the above mentioned object is achieved.

Optionally, the another form of energy is cooling energy.

Optionally, the another form of energy is electric energy.

### Brief description of the drawings

Fig. 1 shows a schematic illustration of an energy system according to some embodiments,
Fig. 2 shows a schematic illustration of an energy system according to some further embodiments,
Fig. 3 shows a schematic illustration of an energy system according to some yet further embodiments.

### Detailed description

The energy system with MVC/MVR-subsystem will now be described in detail with references to the appended figures. Throughout the figures the same, or similar, items have the same reference signs. Moreover, the ,items and the figures are not necessarily to scale, emphasis instead being placed upon illustrating the principles of the invention.

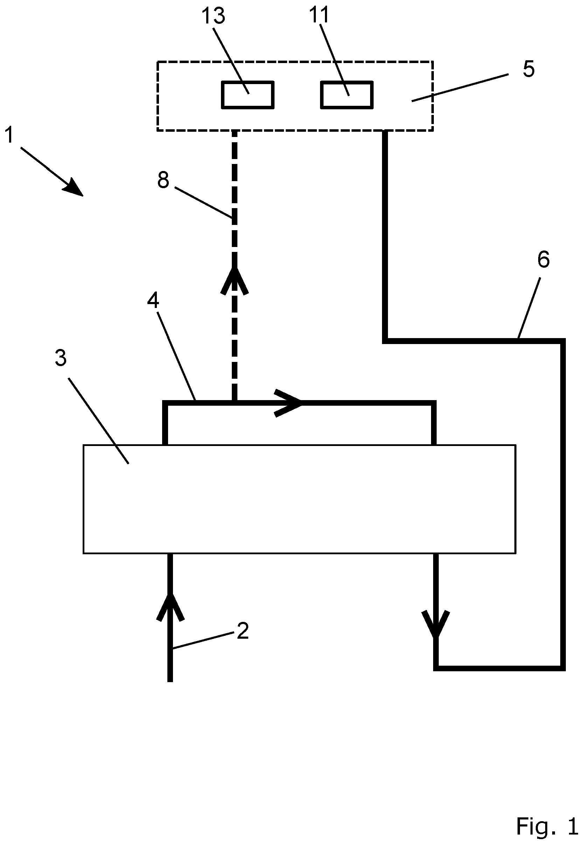

With reference to Fig. 1, an energy system 1 comprising a mechanical vapor compression (MVC) or also called mechanical vapor recompression (MVR) subsystem 3 is illustrated according to some embodiments.

The MVC/MVR-subsystem 3 is a common knowledge in the art and is therefore not described herein in details.

The energy system 1 comprises a mechanical vapor compression (MVC/MVR) subsystem 3. arranged to receive a liquid and arranged to produce compressed vapor from the liquid and to heat the liquid being received. The liquid is supplied to the MVC/MVR-subsystem 3 through a liquid supply line 2. The compressed vapor are transported through a compressed vapor line 4. The heated liquid is transported through a heated liquid line 6.

The liquid may be water or the liquid may be any other liquid or mixture of liquids and/or other materials e.g. solids, polymers, fatty alcohols, oils, additives, soluble or insoluble particles and molecular systems including ionic fluids. The heated liquid may then be a heated cleaned water. Thus, the MVC/MVR-subsystem 3 may be a MVC/MVR liquid purification subsystem, particularly a MVC/MVR water desalination subsystem.

According to the embodiments illustrated in Fig. 1, the energy system 1 comprises an energy subsystem 5 connected to the MVC/MVR-subsystem 3 by means of the heated liquid line 6. The energy subsystem 5 is arranged to use the liquid being heated to convert the energy in the heated liquid into another form of energy that can be useful. The energy subsystem 5 is directly connected to said MVC/MVR-subsystem 3 by means of the heated liquid line 6.

As an alternative, the energy subsystem 5 can utilize a portion of energy produced by the MVC/MVR-subsystem 3 by using directly a portion of the compressed vapor. The portion of the compressed vapor can be supplied to the energy subsystem 5 through a compressed vapor portion line 8 illustrated with dashed line. Thus, the energy subsystem 5 can be directly connected to the MVC/MVR-subsystem 3 by means of the compressed vapor portion line 8 supplying the portion of the compressed vapor to the energy subsystem 5. Consequently, a portion of energy produced by the MVC/MVR-subsystem 3 can be used by direct connection of the energy subsystem 5 to the MVC/MVR-subsystem according to the following alternatives:
- using the liquid being heated in the MVC/MVR-subsystem 3 and supplied to the energy subsystem 5 through the heated liquid line 6 or
- using the portion of the compressed vapor produced in the MVC/MVR-subsystem 3 and supplied through the compressed vapor portion line 8 or
- using both the liquid being heated in the MVC/MVR-subsystem 3 and supplied to the energy subsystem 5 through the heated liquid line 6 and using the portion of the compressed vapor produced in the MVC/MVR-subsystem 3 and supplied through the compressed vapor portion line 8.

According to some embodiments a portion of the heated liquid can be used by the energy subsystem 5.

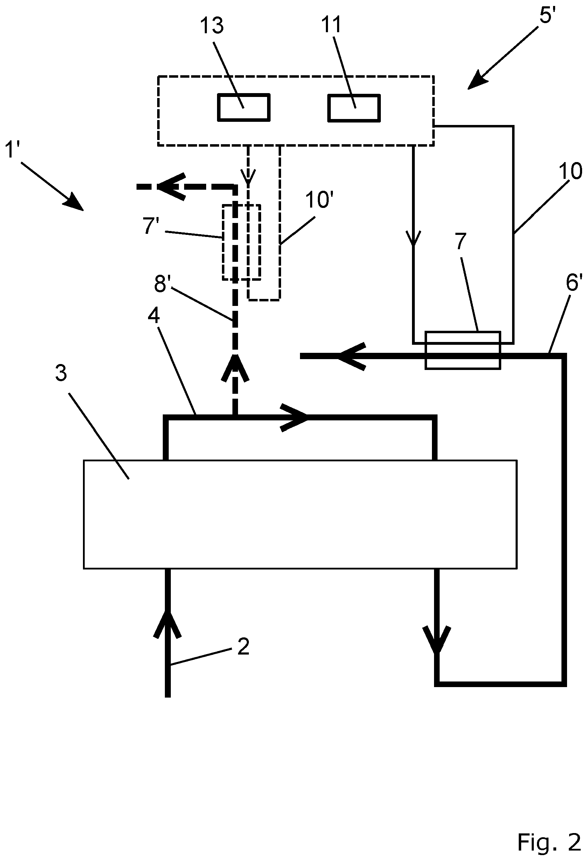

With reference to Fig. 2, an energy system 1' comprising a mechanical vapor compression (MVC/MVR) subsystem 3 and an energy subsystem 5'is illustrated according to further embodiments.

According to the embodiments illustrated in Fig. 2, the energy subsystem 5' comprises a heat exchanger 7 arranged to provide heat exchange between the liquid being heated in the MVC/MVR-subsystem 3 and transported through a further heated liquid line 6' and a heat medium of the energy subsystem 5' flowing via a heat medium line 10.

As an alternative, the energy subsystem 5'may comprises a further heat exchanger 7' arranged to provide heat exchange between the portion of the compressed vapor transported through a further compressed vapor portion line 8' and a further heat medium flowing via a further heat medium line 10'.

Consequently, a portion of energy produced by the MVC/MVR-subsystem 3 can be used by indirect connection of the energy subsystem 5' to the MVC/MVR-subsystem 3 by providing a heat exchange according to the following alternatives:
- arranging the energy subsystem 5' with the heat exchanger 7 arranged to provide heat exchange between the liquid being heated in the MVC/MVR-subsystem 3 and transported through a further heated liquid line 6' and the heat medium of the energy subsystem 5' flowing via the heat medium line 10 or
- arranging the energy subsystem 5' with the further heat exchanger 7' arranged to provide heat exchange between the portion of the compressed vapor transported through the further compressed vapor portion line 8' and the further heat medium flowing via the further heat medium line 10' or
- arranging the energy subsystem with the heat exchanger 7 arranged to provide heat exchange between the liquid being heated in the MVC/MVR-subsystem 3 and transported through a further heated liquid line 6' and the heat medium of the energy subsystem 5' flowing via a heat medium line 10 and with the further heat exchanger 7' arranged to provide heat exchange between the portion of the compressed vapor transported through the further compressed vapor portion line 8' and the further heat medium flowing via the further heat medium line 10'.

The heat medium and the further heat medium may be water or a medium comprising freon or ammonia or other suitable substances.

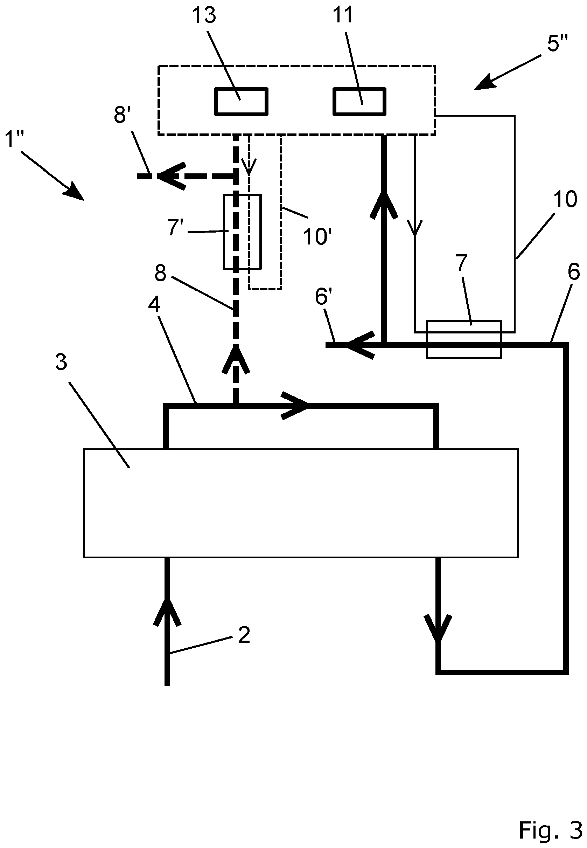

With reference to Fig. 3 an energy system 1" comprising a mechanical vapor recompression MVC/MVR subsystem 3 and an energy subsystem 5" is illustrated according to some further embodiments.

According to the embodiments illustrated in Fig. 3 the energy system 1" is illustrated being a combination of the energy system 1 illustrated in Fig. 1 and the energy system 1' illustrated in Fig. 2. Thus, in Fig. 3 an energy system 1" is illustrated showing possible connections of the energy subsystem 5" to the MVC/MVR-subsystem 3 using possible direct and indirect connection alternatives described in conjunction to Fig. 1 and Fig. 2

The energy subsystems 5.5' and 5" described in conjunction to Fig.1, Fig. 2 and Fig. 3 may comprise a cooling apparatus 11 configured to convert heat to cooling. Thus, heat produced by the MVC/MVR-subsystem 3 can be used to produce cooling, such as for example cooling of residences or cooling in industrial processes. The cooling apparatus 11 may be an absorption chiller or an adsorption chiller. Thus heat energy produced by the MVC/MVR-subsystem 3 can be converted into cooling in an efficient manner by means of an absorption chiller or an adsorption chiller. Another examples of cooling apparatus 11 are: thermodynamic cyclic processes, such as ORC, Stirling cycle, thermo-acoustics, adsorption- or absorption-refrigerators or electro-thermal converters such as Peltier elements.

Optionally, the energy subsystems 5.5' and 5" described in conjunction to Fig.1, Fig. 2 and Fig. 3 may comprise an electric apparatus 13 configured to use heat to generate electricity. Thus, heat produced by the MVC/MVR-subsystem 3 can be used to produce electricity. The electric apparatus 13 may be a thermoelectric generator. Thus, electricity can be produced in an effective manner using heat energy produced by the MVC/MVR-subsystem 3.

Through the application the arrows illustrate the flow direction in the respective line.

## Claims

1. An energy system (1, 1', 1") comprising a mechanical vapor compression (MVC/MVR) subsystem (3) arranged to receive a liquid and arranged to produce compressed vapor from said liquid and to heat the liquid being received,
**characterized in that**
the energy system (1, 1', 1") comprises an energy subsystem (5, 5', 5") connected to said MVC/MVR-subsystem (3) and arranged to convert energy in a portion of said compressed vapor and/or in at least a portion of said liquid being heated into another form of energy.

2. The energy system (1, 1', 1") according to claim 1, wherein said energy subsystem (5, 5', 5") comprises a cooling apparatus (11) configured to convert heat to cooling.

3. The energy system (1, 1', 1") according to claim 2, wherein said cooling apparatus (11) is an absorption chiller or an adsorption chiller.

4. The energy system (1, 1', 1") according to any of claims 1 to 3, wherein said energy subsystem (5, 5', 5") comprises an electric apparatus (13) configured to use heat to generate electricity.

5. The energy system (1, 1', 1") according to claim 4, wherein said electric apparatus (13) is a thermoelectric generator.

6. The energy system (1, 1', 1") according to any of claims 1 to 5, wherein the MVC/MVR-subsystem (3) is arranged as a closed loop vapor MVC/MVR-subsystem.

7. The energy system (1, 1', 1") according to any of claim 1 or 6, wherein the MVC/MVR-subsystem (3) is a MVC/MVR liquid purification subsystem.

8. The energy system (1, 1', 1") according to claim 7, wherein the MVC/MVR liquid purification subsystem is a MVC/MVR water desalination subsystem.

9. The energy system (1, 1', 1") according to any of claims 1 to 8, wherein the liquid is water and the heated liquid is heated cleaned water.

10. A method for converting energy using an energy system (1, 1', 1") comprising a mechanical vapor compression (MVC/MVR) subsystem (3) arranged to receive a liquid and arranged to produce compressed vapor from said liquid and to heat the liquid being received,
**characterized in that**
the method comprises:
- connecting an energy subsystem (5, 5', 5") to said MVC/MVR-subsystem (3) and
- using a portion of said compressed vapor and/or at least a portion of said liquid being heated to convert energy in the portion of said compressed vapor and/or in at least the portion of said liquid being heated into another form of energy by means of said energy subsystem (5, 5', 5").

11. The method according to claim 10, wherein said another form of energy is cooling energy.

12. The method according to claim 10 or 11, wherein said another form of energy is electric energy.
